(19) Europäisches Patentamt
European Patent Office
Office européen des brevets

(11) Numéro de publication: **0 082 094**
**B1**

# (12) FASCICULE DE BREVET EUROPEEN

(45) Date de publication du fascicule du brevet: **10.12.86**

(51) Int. Cl.[4]: **C 25 D 5/56,** C 23 C 18/20

(21) Numéro de dépôt: **82420173.5**

(22) Date de dépôt: **06.12.82**

(54) **Procédé de métallisation d'articles électriquement isolants en matière plastique et les articles intermédiaires pour sa mise en oeuvre.**

(30) Priorité: **14.12.81 FR 8123472**

(43) Date de publication de la demande:
**22.06.83 Bulletin 83/25**

(45) Mention de la délivrance du brevet:
**10.12.86 Bulletin 86/50**

(84) Etats contractants désignés:
**BE DE GB IT NL SE**

(56) Documents cités:
**DE - A - 2 141 759**
**US - A - 3 226 256**
**US - A - 3 347 724**
**US - A - 3 764 280**

**CHEMICAL ABSTRACTS, vol. 76, no. 12, 20 mars 1972, page 317, no. 63968m, Columbus Ohio (USA); A. PROKOPCIKAS et al.: "Reduction of copper subgroup metal compounds by sodium borohydride in alkaline solutions".**
**CHEMICAL ABSTRACTS, vol. 94, no. 12, 23 mars 1981, page 742, no. 94824n, Columbus Ohio (USA)**
**Condensed Chemical Dictionary, 10th Ed., Hawley**

**Le dossier contient des informations techniques présentées postérieurement au dépôt de la demande et ne figurant pas dans le présent fascicule.**

(73) Titulaire: **RHONE-POULENC SPECIALITES CHIMIQUES, "Les Miroirs" 18, Avenue d'Alsace, F-92400 Courbevoie (FR)**

(72) Inventeur: **Cassat, Robert, Chemin de Crapon, F-69390 Ternay (FR)**

(74) Mandataire: **Varnière-Grange, Monique et al, RHONE-POULENC INTERSERVICES Service Brevets Chimie Centre de Recherches de Saint-Fons B.P. 62, F-69192 Saint-Fons Cédex (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).



ACTORUM AG

## Description

La présente invention a pour objet un procédé de métallisation d'articles électriquement isolants en matière plastique. Elle concerne également les produits intermédiaires pour la mise en œuvre de ce procédé. La présente invention a trait plus particulièrement à un procédé permettant d'appliquer des dépôts métalliques très adhérents et ductiles sur des supports souples ou rigides en faisant appel aussi bien à des moyens électrochimiques qu'à des moyens électrolytiques.

La surface des objets plastiques peut être recouverte d'un métal quelconque (nickel, cuivre, chrome, argent, etc.) qui leur confère un aspect métallique brillant (le plus souvent), mat ou satiné. Il en découle les propriétés suivantes: conductibilité superficielle de l'électricité (d'où d'importantes applications dans le domaine des circuits imprimés); aspect de surface particulier (d'où les applications pour réaliser des éléments décoratifs et des réflecteurs de lumière, pour donner un état de surface particulièrement régulier, pour conférer une bonne démoulabilité); amélioration de la dureté superficielle et de la résistance à l'abrasion (d'où les applications pour réaliser des moules en matière plastique utilisables notamment dans le domaine de la fonderie pour confectionner des noyaux de sable); résistance aux corrosions et aux attaques chimiques de certaines matières plastiques; perméabilité aux gaz et aux vapeurs très réduite, voire même nulle; conductibilité de la chaleur (d'où les applications pour éliminer plus facilement les calories d'une pièce en matière plastique avec comme conséquences une stabilité thermique accrue et une température de déformation du plastique par la chaleur nettement plus élevée); possibilité d'unir par soudure l'article métallisé à un ou plusieurs objets en métal ou en plastique métallisé. Le prix de revient de l'article métallisé est généralement inférieur à celui du même objet réalisé en n'importe quel autre matériau métallique. En effet, l'article plastique est obtenu fini à la sortie de l'appareil de moulage (par compression, coulée, etc.), donc prêt aux traitements de revêtement.

Au cours des deux dernières décennies environ, on a effectué un travail considérable pour résoudre les problèmes rencontrés dans le revêtement par un métal de supports isolants électriquement tels que des résines polymériques renforcées ou non. De manière classique, la métallisation comprend trois étapes principales: une étape de préparation des surfaces, une étape de sensibilisation et d'activation, et une étape de métallisation par voie électrochimique sans courant (ne faisant donc pas appel à des connections électriques) désignée dans ce qui suit par «voie chimique». Lors de la préparation des surfaces, l'opération essentielle consiste dans le décapage (ou déglaçage) acide par voie oxydante qui attaque la surface résineuse de manière à créer des microporosités pour favoriser l'accrochage ultérieur de particules métalliques qui serviront de sites d'amorçage pour la croissance de la métallisation électrochimique; cette opération est réalisée par immersion pendant quelques minutes dans une solution aqueuse concentrée sulfochromique (à noter qu'il s'agit là d'un procédé assez coûteux par suite de la destruction de l'acide chromique qui devient, par réduction, de l'oxyde de chrome-III). Les opérations de sensibilisation et d'activation qui suivent ont pour but de former une couche extérieure discontinue de particules métalliques (ou sites d'amorçage) à partir desquelles on réalisera, lors de l'étape suivante, une mince couche métallique par voie chimique; la sensibilisation peut être réalisée par immersion dans une solution acide de sels stanneux; l'activation qui suit la sensibilisation consiste à tremper l'article dans une solution aqueuse d'un sel d'un métal noble des groupes IB et VIII de la classification périodique (telle que publiée dans l'ouvrage Handbook of Chemistry and Physics, 45ème édition, 1964–1965), généralement le palladium. On peut aussi effectuer la sensibilisation et l'activation en une seule phase, en trempant le substrat isolant par exemple dans une solution acide contenant à la fois des sels d'étain et de palladium; cette solution est le siège d'une réaction d'oxydoréduction entre l'étain et le palladium conduisant à la formation de palladium colloïdal qui s'adsorbe sur le substrat. L'étape suivante de métallisation par voie chimique consiste à soumettre le substrat ainsi activé à l'action d'un bain de métallisation qui est une solution aqueuse comprenant notamment un sel soluble dans l'eau du métal à déposer et un agent de réduction capable de transformer le sel métallique en métal. La qualité de la métallisation, en particulier l'adhérence du métal déposé, dépend du degré d'adsorption des amorces métalliques (palladium); la qualité de la métallisation est donc étroitement liée à l'état de surface du substrat isolant. L'homme de l'art qui souhaite utiliser cette technique ne peut pas s'affranchir, dans un souci de simplification, du traitement préalable de la surface qui est important. De plus, lors de cette étape et aussi lors de l'étape ultérieure de sensibilisation et d'activation, il pourra être confronté à un problème de dégradation de la résine au contact des bains acides utilisés. A noter encore, lors de l'étape de sensibilisation et d'activation, qu'il pourra être confronté encore à un problème de mouillabilité insuffisante de la résine qui gênera le contact du ou des bains mis en œuvre avec le substrat. En définitive, la technique qui vient d'être expliquée comporte de nombreuses étapes et d'autre part elle n'est pas exempte d'inconvénients. Nous avons parlé jusqu'ici de trois étapes, mais il en existe une quatrième qui consiste à renforcer au besoin la couche de métal obtenue par une métallisation ultérieure par voie électrolytique; c'est le cas notamment lorsque l'on veut pouvoir disposer d'une couche métallique épaisse. La métallisation chimique est une méthode lente dont la vitesse de dépôt est de l'ordre de 1 µm par heure; elle perd donc tout son intérêt quand il s'agit d'obtenir des couches métalliques dont l'épaisseur va dépasser 20 µm environ. Pour obtenir de pareilles couches

épaisses, on procède en général d'abord à un dépôt chimique de l'ordre de quelques µm par exemple, puis on effectue ensuite un second dépôt par voie électrolytique. La voie électrolytique est incomparablement plus rapide, puisque sa vitesse de dépôt est de l'ordre de 50 µm environ par heure. Il convient de noter, et il s'agit là d'une autre critique à l'égard de la technique classique expliquée ci-avant, que la métallisation par voie électrolytique ne peut justement pas être faite directement après l'étape d'activation du substrat, ceci étant lié au fait que la surface discontinue de particules métalliques obtenue n'est pas suffisamment conductrice, d'où la nécessité de passer dans ce cas par l'intermédiaire d'une croissance chimique pour obtenir la conductibilité électrique nécessaire.

La possibilité d'obtenir bien plus simplement des sites métalliques d'amorçage dans le substrat a été suggérée par le brevet américain N° 2 690 401 qui propose d'introduire dans la résine, à titre de charge, de fines particules métalliques, comme par exemple des particules d'aluminium. Ces particules métalliques finement divisées sont cependant particulièrement sensibles à l'oxydation et elles vont se couvrir rapidement d'une couche d'oxyde non conducteur quand elles seront exposées à l'air notamment pendant la fabrication du substrat; il conviendra donc en général de procéder avant métallisation à un décapage délicat des surfaces à métalliser (généralement par voie acide) de manière à retrouver la conductivité électrique souhaitée. L'emploi de métaux nobles supprime certes les risques d'oxydation, mais ils sont dans la plupart des cas trop coûteux pour pouvoir faire l'objet d'une mise en œuvre industrielle avantageuse. Pour minimiser les risques d'oxydation, on a proposé de faire appel à des particules métalliques (non nobles) de dimensions plus importantes. Cependant, dans ce cas, le même taux pondéral de charge métallique dans le substrat va conduire à une densité superficielle de sites d'amorçage plus faible et la croissance chimique se fera de façon modulaire sans aucune continuité. Enfin la répartition dans le substrat résineux de particules métalliques en quantité suffisante pour permettre une densité superficielle de sites d'amorçage compatible avec une croissance chimique continue, va interdire l'emploi de cette technique pour la fabrication de circuits imprimés car des pontages conducteurs pourront exister dans la masse du substrat ainsi chargé.

Pour tourner cette difficulté, il est possible de faire appel à la technique décrite dans le brevet américain N° 3 347 724 qui consiste à préparer un substrat chargé avec de fines particules d'oxyde cuivreux non conducteur et à soumettre, juste avant l'étape de métallisation, les parties superficielles du substrat que l'on souhaite métalliser à une réduction par un traitement acide pour transformer l'oxyde cuivreux en cuivre métallique. On sait que la réduction de l'oxyde cuivreux par un acide fait intervenir la formation d'un sel cuivreux instable qui se dismute pour donner d'une part un sel cuivrique et d'autre part du cuivre métallique qui est libéré selon la réaction:

$$Cu_2O + {}_2H^+ \rightarrow Cu^{++} + Cu + H_2O$$

Dans une telle réduction le rendement en cuivre métallique est bien inférieur à 50%: en effet la moitié seulement du cuivre de départ est susceptible de se transformer en cuivre métallique et de plus une partie de ce cuivre réduit est dissoute par l'agent acide utilisé. Le résultat en est que la densité des sites métalliques d'amorçage par unité de surface qui peut être obtenue est limitée. Elle convient certes pour procéder ensuite à une métallisation par voie chimique, mais elle est insuffisante pour permettre une métallisation directement par voie électrolytique. Il est en effet indiqué dans ce brevet qu'il est difficile ou même impossible de procéder à une métallisation par galvanoplastie. On retrouve donc dans cette technique le même inconvénient que celui mentionné à propos de la technique classique expliquée ci-avant, consistant, pour obtenir des dépôts métalliques épais, à devoir procéder à deux étapes successives de métallisation: une par voie chimique et une seconde par voie électrolytique.

En définitive, la nécessité se faisant sentir de développer une technique de métallisation améliorée: par sa simplicité (pas de sensibilisation et d'activation, pas de décapage délicat de la charge métallique incluse dans le substrat), par son faible coût (pas d'emploi de sels de palladium ou de métaux pulvérulents nobles), qui puisse permettre d'engendrer, avant métallisation, une densité élevée de sites d'amorçage autorisant ensuite une métallisation électrolytique directe sans obligation de passer par l'intermédiaire d'une croissance chimique et qui soit applicable à la confection de tous les articles souhaités, notamment des circuits imprimés.

Il a maintenant été trouvé et c'est ce qui constitue l'un des objets de la présente invention, un procédé de métallisation de substrats en matière plastique qui permet de satisfaire les objectifs définis ci-avant.

Plus précisément, la présente invention concerne un procédé de métallisation de substrats en matière plastique selon lequel on réalise d'abord un substrat isolant électriquement de forme appropriée consistant dans l'association d'une résine polymérique et de particules d'oxyde cuivreux et le cas échéant une ou plusieurs autres charges non conductrices et inertes dans les conditions de la réduction, on réduit au moins une partie de l'oxyde cuivreux en cuivre métallique, puis on procède ensuite au dépôt de la couche métallique souhaitée, ledit procédé étant caractérisé en ce que:

(a) la ou les surface(s) du substrat destinée(s) à recevoir, en tout ou partie, la couche métallique est (sont) soumise(s), avant le dépôt de la couche en question, à l'action réductrice d'un borohydrure;

(b) on opère la réduction avec le borohydrure de façon que la résistivité superficielle soit comprise entre 0,01 et $10^3$ Ω/□, avant le dépôt de la couche métallique souhaitée et,

(c) le dépôt de la couche est fait par voie électrochimique sans courant et/ou par voie électrolytique.

Un autre objet de l'invention réside dans les articles «intermédiaires» mis en œuvre dans le cadre du présent procédé, à savoir les substrats constitués par l'association d'une résine polymérique avec des particules d'oxyde cuivreux et le cas échéant une ou plusieurs charges non conductrices électriquement et inertes dans les conditions de la réduction, obtenus après traitement avec un borohydrure et dont la partie réduite présente avant dépôt de la couche métallique souhaitée une résistivité superficielle comprise entre environ 0,01 Ω/□ et environ $10^3$ Ω/□.

Les substrats métallisés obtenus par application du présent procédé peuvent être des objets métallisés entrant dans le domaine de nombreuses industries: automobile: encadrements de compteurs, de radios, de poignées de portes, de lève-glaces, de calandres, de boutons divers de tableaux de bord, de projecteurs, de lanternes arrières, de feux divers, etc.; radio, télévision, électronique: boîtiers et encadrements de postes de radio et de télévision, filaments conducteurs, circuits imprimés, boutons divers; articles sanitaires et ménagers: béquilles pour portes et fenêtres, accessoires divers d'appareils sanitaires et ménagers; articles appartenant au domaine des techniques aérospatiales.

L'obtention des valeurs de résistivité souhaitées pour le substrat, avant métallisation, va dépendre d'une part des proportions d'oxyde cuivreux compris dans le substrat et d'autre part de l'importance de la réduction opérée.

De préférence, les proportions des constituants d'un substrat conforme à la présente invention sont choisies entre les limites suivantes (exprimant le pourcentage pondéral de chacun des constituants dans le substrat):
- de 25 à 90% d'oxyde cuivreux,
- de 0 à 50% d'autre(s) charge(s) inertes dans les conditions de la réduction,
- de 10 à 75% de résine polymérique.

S'agissant de l'oxyde cuivreux utilisé, il doit se présenter sous la forme de particules de petites dimensions; la granulométrie est en général comprise entre 0,1 et 5 µm.

En plus des particules d'oxyde cuivreux, le substrat peut contenir une ou plusieurs autres charges isolantes électriquement totalement inertes dans les conditions de la réduction. Il peut s'agir notamment de charges de renforcement comme par exemple: des matières formées de fibres simples, de nature minérale ou organique, dont la longueur n'excède pas en général 10 mm, telles que notamment des fibres d'amiante, de céramique ou de préférence de verre ou des matières de renforcement de grande longueur: fils, tissus, non-tissés, tricots; des matières formées de grains, de nature minérale ou organique, présentant une granulométrie comprise entre 20 µm et 5 mm, telles que des particules de mica, de sulfure de molybdène, d'alumine, de silice, de polytétrafluoroéthylène ou de préférence de microbilles de verre.

Les résines au sein desquelles sont uniformément dispersées les particules d'oxyde cuivreux mais aussi la ou les autres charges quand il y en a, peuvent être des résines thermoplastiques, des résines thermodurcissables des élastomères et des mélanges de ces résines entre elles. A noter que l'emploi de résines thermodurcissables ou de mélanges en contenant est particulièrement avantageux pour apporter au substrat une bonne résistance à la chaleur.

Comme résines thermoplastiques typiques, on citera notamment: les résines polyoléfiniques, illustrées par exemple par le polyéthylène, le polypropylène, les copolymères éthylène-propylène; les résines vinyliques, illustrées par exemple par le polychlorure de vinyle, le polychlorure de vinylidène, les copolymères éthylène-acétate de vinyle; les résines polystyréniques, illustrées par exemple par le polystyrène ordinaire, les copolymères styrène-butadiène, styrène-acrylonitrile, styrène-butadiène-acrylonitrile; les résines polyamidiques, illustrées par exemple par le polyhexaméthylène-adipamide (type 6–6), le polyaminocaprolactame (type 6), le polyundécanamide (type 11); les résines acryliques, illustrées par exemple par le polyméthacrylate de méthyle; les polyuréthanes linéaires, illustrés par exemple par les produits de réaction du di-isocyanate d'hexaméthylène sur le propanediol-1,3 ou le butanediol-1,4; les polyesters saturés, illustrés par exemple par le polytéréphtalate d'éthylèneglycol ou de butylèneglycol; les fluorées; les polycarbonates; les polyacétals; les polyphénylène oxydes; les polyphénylène sulfures ou les élastomères thermoplastiques.

Comme résines thermodurcissable typiques, on citera notamment: les résines phénoliques, illustrées par exemple par les condensats de phénol, résorcinol, crésol ou xylénol avec du formaldéhyde ou du furfural; les polyesters insaturés, illustrés par exemple par les produits de réaction d'un anhydride d'acide dicarboxylique non saturé comme l'anhydride maléique ou citraconique avec un polyalkylèneglycol; les résines époxydiques, illustrées par exemple par les produits de réaction du chloro-1 époxy-2,3 propane ou du diépoxy-1,2,3,4 butane avec le bis-phénol A ou d'autres phénols comme le résorcinol, l'hydroquinone ou le dihydroxy-1,5 naphtalène; les résines polyimidiques, illustrées par exemple par les produits de réaction d'un oligoimide dérivé d'acide dicarboxylique non saturé avec une polyamine primaire et éventuellement un adjuvant approprié.

Comme élastomères on citera entre autre les caoutchoucs naturels ou synthétiques, les silicones, les polyuréthanes etc...

De manière habituelle, la préparation du substrat à métalliser consiste à mélanger intimement, de manière connue en soi, la résine avec la charge (oxyde cuivreux + éventuellement charge(s) inerte(s)). Si la résine est liquide dans les conditions de température choisies pour faire ce

mélange, la qualité uniforme du mélange peut être améliorée par passage sur un cylindre. Si la résine est solide, il est recommandé d'effectuer en plus un broyage du mélange. Dans le cas des résines thermodurcissables, la matière polymérique utilisée au départ pour faire le mélange se trouve en général à l'état de prépolymère (matière présentant un certain point de ramollissement et étant encore soluble dans certains solvants). A noter que dans le substrat fini, tel qu'il est utilisé pour la métallisation, la résine thermodurcissable est alors à l'état complètement réticulé (la matière est infusible et totalement insoluble). La résine chargée (dans le cas des thermoplastiques) ou le prépolymère chargé (dans le cas des thermodurcissables) peut être utilisé à l'état de masse liquide pour réaliser l'article voulu par simple coulée à chaud dans un moule de forme appropriée. On peut aussi l'utiliser sous la forme de poudre pour réaliser le moulage par extrusion ou injection (dans le cas des thermoplastiques de préférence) ou par compression ou transfert (dans le cas des thermodurcissables de préférence) ou encore par frittage. En matière de résines thermodurcissables, on a prévu ci-avant de mélanger la charge avec le prépolymère préparé séparément, mais on peut effectuer aussi la pré-polymérisation en présence de la charge. Toujours en matière de thermodurcissables, il convient après moulage de faire subir un durcissement à l'article conformé obtenu, une mise en forme complémentaire pouvant être effectuée pendant ce durcissement. De manière bien connue, le durcissement est opéré grâce à l'intervention d'un catalyseur ou d'un durcisseur ajouté de préférence au moment du moulage ou encore sous l'action de la chaleur ou encore sous l'action conjuguée d'un catalyseur ou durcisseur et de la chaleur.

De manière préférentielle, la résine thermoplastique utilisée pour la mise en œuvre de l'invention consiste en une résine polyamide appartenant aux types 6–6, 6 ou 11 ou copolymères.

De manière préférentielle encore, la résine thermodurcissable utilisée consiste en une résine époxydique obtenue par réaction du chloro-1 époxy-2,3 propane ou du diépoxy-1,2,3,4 butane avec le bis-phénol A ou en une résine polyimidique obtenue par réaction entre un N,N′-bis-imide d'acide dicarboxylique insaturé et une polyamine primaire selon les indications données dans le brevet français N° 1 555 564, dans les brevets américains N° 3 562 223 et 3 658 764 et dans la réissue américaine N° 29 316. La résine polyimide choisie peut encore être obtenue par réaction entre le bis-imide, la polyamine et divers adjuvants tels que par exemple des mono-imides (selon le brevet français N° 2 046 498), des monomères, autres que des imides, comportant un ou plusieurs groupements polymérisables du type $CH_2 = C<$ (selon le brevet français N° 2 094 607), des polyesters insaturés (selon le brevet français N° 2 102 878) ou des composés organosiliciques hydroxylés (selon le brevet français N° 2 422 696). Dans le cas où l'on utilise de pareils adjuvants, il faut mentionner que la résine polyimide à l'état de prépolymère peut être soit le produit de réaction d'un bis-imide, d'une polyamine avec un adjuvant, soit le produit de réaction d'un prépolymère de bis-imide et de polyamine avec un adjuvant, soit encore le mélange d'un prépolymère de bis-imide et de polyamine avec un adjuvant.

S'agissant de la résine époxydique, le durcissement est opéré grâce à l'intervention d'un durcisseur appartenant aux groupes suivants: des anhydrides comme par exemple l'anhydride phtalique, tétrahydrophtalique, maléique; des amines aliphatiques ou aromatiques simples, des polyamines, des amides ou même des résines aminoplastes comme par exemple la triéthanolamine, la diéthylène-triamine, la tri-éthylène tétramine, le dicyano-diamide ou une résine mélamine-formol; des durcisseurs divers comme par exemple des prépolymères phénoliques, des prépolymères polyimides tels que ceux mentionnés ci-avant, du fluorure de bore ou du tétrachlorure d'étain. S'agissant de la résine du type polyimide, le durcissement est opéré en général sous l'action de la chaleur, mais il peut être avantageux de l'accélérer par l'emploi d'un initiateur de polymérisation radicalaire tel que par exemple le peroxyde de dicumyle, le peroxyde de lauroyle, l'azobisisobutyronitrile ou d'un catalyseur de polymérisation anionique tel que par exemple le diazabicyclooctane. Le durcisseur ou le catalyseur utilisé peut être apporté dans la résine en mélange avec la charge, mais son introduction est réalisée de préférence après l'incorporation de la charge. Les quantités utilisées qui sont très variables sont bien connues de l'homme de l'art et elles ne présentent aucun caractère critique. Il convient de préciser que les chiffres donnés ci-avant à propos des proportions pondérales de résine polymérique entrant dans la constitution des substrats conforme à l'invention englobent la quantité de durcisseur ou catalyseur éventuellement mis en œuvre.

Suivant les caractéristiques physiques de la résine utilisée et suivant aussi la technique de moulage utilisée, il peut arriver que la charge, notamment l'oxyde cuivreux, soit complètement revêtue par la matière polymérique. Dans ce cas, il est recommandé de traiter la surface par exemple à l'aide d'un agent chimique doux n'attaquant la résine que très superficiellement sans toucher à l'oxyde ou de préférence à l'aide d'un moyen mécanique comme le sablage, le ponçage, le meulage, le limage, etc., pour faire apparaître les particules d'oxyde avant de procéder au traitement réducteur. A noter que dans le cas de la réalisation d'une pièce par frittage, par filage ou par extrusion, les particules d'oxyde en surface ne sont généralement pas complètement revêtues par la résine: le décapage superficiel n'est alors pas nécessaire.

Il a été indiqué ci-avant que la résistivité superficielle que l'on souhaite obtenir, avant métallisation, va dépendre, outre de la composition du substrat, de l'importance de la réduction opérée. Cela conduit à examiner maintenant plus en détail

la nature du traitement réducteur effectué avant métallisation.

On a constaté que la transformation de l'oxyde cuivreux en cuivre métallique peut être conduite facilement et de manière quantitative par action des borohydrures. La transformation est représentée par la réaction:

$$_4Cu_2O + BH_4^- \rightarrow {}_8Cu + B(OH)_3 + OH^-$$

Cette facilité de réaction est probablement due à l'effet catalytique du cuivre métal qui pourrait s'expliquer par la formation intermédiaire d'hydrure de cuivre instable.

Les borohydrures utilisables dans la présente invention englobent des borohydrures substitués aussi bien qu des borohydrures non substitués. Des borohydrures substitués dans lesquels au plus trois atomes d'hydrogène de l'ion borohydrure ont été remplacés par des substituants inertes dans les conditions de réduction comme par exemple des radicaux alkyles, des radicaux aryles, des radicaux alkoxy peuvent être utilisés. On fait appel de préférence à des borohydrures alcalins dans lesquels la partie alcaline consiste en du sodium ou du potassium. Des exemples typiques de composés qui conviennent sont: le borohydrure de sodium, le borohydrure de potassium, le diéthylborohydrure de sodium, le triméthoxyborohydrure de sodium, le triphénylborohydrure de potassium.

Le traitement réducteur est conduit de manière simple par mise en contact de la pièce après mise en forme avec une solution de borohydrure dans l'eau ou dans un mélange d'eau et d'un solvant polaire inerte comme par exemple un alcool aliphatique inférieur. On donne la préférence aux solutions purement de borohydrure. La concentration de ces solutions peut varier dans de larges limites et elle se situe de préférence entre 0,05 et 1% (en poids d'hydrogène actif du borohydrure dans la solution). Le traitement réducteur peut être effectué à température élevée, cependant on préfère le mettre en œuvre à une température voisine de la température ambiante, par exemple entre 15 et 30 °C. A propos du déroulement de la réaction, il faut noter qu'elle donne naissance à du $B(OH)_3$ et à des ions $OH^-$ qui ont pour effet d'induire une augmentation du pH du milieu au cours de la réduction. Or à des valeurs de pH élevées, par exemple supérieures à 13, la réduction est ralentie de sorte qu'il peut être avantageux d'opérer dans un milieu tamponné pour avoir une vitesse de réduction bien fixée.

En début de réduction, la réaction concerne essentiellement les grains d'oxyde cuivreux qui se trouvent en surface du substrat et qui sont en contact direct avec l'agent réducteur. Du fait de l'effet catalytique du cuivre métal, la réaction de réduction va se produire ensuite dans l'épaisseur du substrat et ceci bien que les résines utilisées ne présentent pas un caractère hydrophile particulièrement marqué. C'est donc en jouant principalement sur la durée du traitement qu'il est possible de contrôler aisément l'importance de la réduction opérée. Pour obtenir une résistivité répondant aux valeurs souhaitées, la durée du traitement qui est nécessaire est en général assez courte et, selon les proportions d'oxyde compris dans le substrat, elle se situe habituellement entre environ une minute et une quinzaine de minutes. Pour une durée de traitement donnée, il est possible d'agir encore sur la vitesse de réduction en ajoutant dans le milieu des accélérateurs variés comme par exemple de l'acide borique, de l'acide oxalique, de l'acide citrique, de l'acide tartrique ou des chlorures de métaux tels que le chlorure de cobalt-II, de nickel-II, de fer-II, de manganèse-II, de cuivre-II.

La réduction qui est opérée dans l'intervalle de temps indiqué ci-avant peut concerner une partie seulement de l'épaisseur du substrat ou bien la totalité de cette épaisseur. Tout va dépendre bien entendu de l'épaisseur du substrat et de la durée du traitement réducteur. Il est à prévoir, dans le cas où le substrat est épais et où l'on souhaite propager la réduction dans une partie importante ou dans la totalité de l'épaisseur, qu'une durée de traitement supérieure à celle indiquée ci-avant pourra être nécessaire. De manière générale, la durée indiquée ci-avant est toujours suffisante pour développer une résistivité répondant aux valeurs souhaitées. A noter que pour des applications électriques ou électroniques, on veillera à ne réduire de préférence qu'une partie seulement de l'épaisseur du substrat afin de conserver une partie interne non réduite isolante pour éviter tout phénomène parasite de pontage conducteur.

Etant donné l'état très divisé du cuivre obtenu après le traitement réducteur, on devait s'attendre à ce que son oxydation à l'air soit rapide. Or on a constaté qu'il n'en est rien et que le niveau de la résistivité superficielle du substrat après réduction n'évolue pas pendant plusieurs jours de conservation à l'air ambiant.

Après le traitement réducteur, le substrat est métallisé par dépôt d'une couche de cuivre, de nickel ou d'un autre métal. Cette métallisation peut être faite par voie chimique, mais il a été constaté et ceci constitue un des avantages essentiels liés à la mise en œuvre de la présente invention, qu'elle peut être faite aussi directement par voie électrolytique. Dans certaines applications, il n'est pas rare de rechercher un dépôt de couche métallique d'au moins 20 µm environ, aussi la possibilité de pouvoir utiliser directement la voie électrolytique correspond-elle vraiment à une économie de temps appréciable. Il est possible bien entendu de procéder, de manière classique, d'abord à une métallisation chimique, puis renforcement de ce premier dépôt par un dépôt ultérieur électrolytique.

La métallisation chimique est réalisée par immersion du substrat, après réduction, dans une solution aqueuse acide ou alcaline contenant un sel soluble dans l'eau du métal ou des métaux à déposer et un réducteur. En solution acide, on utilise un agent tampon tel qu'un sel soluble dans l'eau dérivé d'un acide carboxylique ayant une constante d'ionisation, pKa, dans l'eau supérieure

à 4 comme par exemple l'acide acétique, l'acide butyrique, l'acide propionique. En solution alcaline, un agent comme du chlorure ou de l'hydroxyde d'ammonium est utilisé pour maintenir un pH alcalin. Le nickel est généralement utilisé comme métal de dépôt chimique. D'autres métaux tels que par exemple le cobalt, le chrome, le cuivre, le fer, l'argent, l'or, le vanadium, des alliages cobalt-nickel, le laiton peuvent aussi être déposés. Pour l'emploi avec le nickel un réducteur tel que l'hypophosphite de sodium est recommandé. D'autres réducteurs chimiques existent et sont bien connus de l'état de la technique. Pour avoir une description plus détaillée des conditions opératoires propres à la métallisation chimique, on peut se reporter à l'ouvrage «Encyclopedia of Polymer Science and Technology, 1968, volume 8, pages 658 à 661». Les proportions des constituants du bain chimique, la durée de l'immersion du substrat, la température et les autres conditions opératoires sont déterminées dans chaque cas particulier de manière connue en soi pour obtenir les meilleurs résultats.

La métallisation par électrolyse est également bien connue; cf. notamment «Encyclopedia of Polymer Science and Technology, 1968, volume 8, pages 661 à 663». Le substrat convenablement réduit constitue la cathode et le métal à déposer l'anode. Tous deux sont immergés dans un électrolyte traversé par un courant. Par exemple dans le cas d'un cuivrage électrolytique, le cuivre déposé peut être monovalent ou bivalent et provenir d'un électrolyte cyanuré (cuivre monovalent) ou d'un électrolyte à base de sulfate, pyrophosphate ou fluoborate (cuivre bivalent). Plusieurs adjuvants peuvent être ajoutés dans l'électrolyte: un sel alcalin ou alcalino-terreux, un acide (bain de cuivrage acide au sulfate de cuivre) ou une base (bain d'étamage alcalin au stannate) pour augmenter la conductivité de l'électrolyte; un agent tampon pour éviter les variations rapides du pH; des corps modifiant la structure des électrodépôts comme par exemple des colloïdes, des agents tensio-actifs, un phénol, un phénol sulfoné, un brillanteur minéral ou organique, un agent nivelant tel que par exemple la coumarine. La qualité de l'électrodépôt, qu'il soit d'un métal ou d'un alliage métallique, va dépendre de la composition de l'électrolyte et des conditions physiques de l'électrolyse (température, densité de courant cathodique et anodique distance anode-cathode, conditions superficielles des électrodes, etc.); le réglage de ces différents paramètres sera fait dans chaque cas particulier de manière connue en soi.

Le fait de pouvoir propager la réduction dans l'épaisseur du substrat va permettre d'engendrer les avantages suivants: lors de la métallisation, il y aura un ancrage profond du métal déposé dans le substrat résineux; dans le cas d'une soudure avec un apport de métal formant un alliage, l'alliage pourra migrer également à l'intérieur du substrat puisqu'il y a une réelle continuité du cuivre dans l'épaisseur du substrat; dans le cas d'une métallisation destinée à jouer le rôle de drain thermique, il sera possible d'agir sur le transfert thermique de la résine en faisant progresser plus ou moins la réduction dans la masse du substrat.

Il va de soi que des modifications peuvent être apportées aux modes de réalisation qui viennent d'être décrits.

Les exemples suivants donnés à titre non limitatif illustrent l'invention et montrent comment elle peut être mise en œuvre.

EXEMPLE 1:

On réalise un mélange à sec de 70 parts en poids d'oxyde cuivreux dont les grains présentent une granulométrie comprise entre 0,5 et 3 µm avec 30 parts en poids d'une poudre de granulométrie inférieure à 30 µm d'un prépolymère préparé à partir de N,N'-4,4'-diphénylméthane-bismaléimide et de diamino-4,4'-diphénylméthane (rapport molaire bis-imide/diamine: 2,5) présentant un point de ramollissement de 105 °C. Ce mélange, dans lequel on incorpore encore 0,3 part de peroxyde de dicumyle, est passé sur un broyeur à couteaux CNTA pour en parfaire l'homogénéité.

On prélève 54 g du mélange broyé obtenu et on le pastille à froid sous $200.10^5$ Pa pour conduire à un disque de 50 mm de diamètre. Ce disque est ensuite introduit dans un moule de dimensions 100 × 100 mm préchauffé à 180 °C. La température de 200 °C est alors affichée sur le régulateur thermique de la presse et sous l'effet de son seul poids le piston du moule descend progressivement au fur et à mesure que la matière polymérique flue. Au bout de 7 minutes après la fin de la descente naturelle du piston, la pression est portée à $200.10^5$ Pa et laissée à cette valeur pendant 15 minutes. On effectue ensuite un démoulage à chaud.

On obtient de cette manière une plaquette parallélépipédique de dimensions 100 × 100 × 2 mm. Ladite plaquette, après refroidissement, est polie sur ses deux grandes faces par un papier abrasif doux (papier 600) et elle est découpée en quatre carrés de 45 mm de côté.

Ces articles carrés (ou échantillons) sont alors dépoussiérés par passage pendant quelques minutes dans l'eau d'une cuve à ultrasons, puis plongés pendant 5 minutes dans une solution aqueuse de borohydrure de sodium présentant une concentration de 1% en poids. La solution de réduction est à la température ambiante, soit environ 20 °C, et elle est agitée. Au bout des 5 minutes de traitement, les articles carrés obtenus présentent des résistivités superficielles qui sont inférieures à 1 Ω/□. La réduction opérée concerne une épaisseur de substrat de l'ordre de quelques µm.

Il est ensuite procédé à un cuivrage électrolytique dans un électrolyte contenant:

- sulfate de cuivre ($CuSO_4$,5 $H_2O$): 75 g/l
- $H_2SO_4$: 10 g/l
- chlorure ($Cl^-$): 50 mg/l
- additif pour bain de cuivrage au sulfate acide, commercialisé par la Société RHONE-POULENC sous la dénomination RP 500®: 5 ml/l.

L'additif RP 500 permet d'obtenir des dépôts de cuivre brillants, ductiles, nivelants et sans tension interne.

Les conditions de l'électrolyse sont les suivantes:

| Echantillon | Température °C | Densité de courant A/$dm_2$ | Durée en minute |
|---|---|---|---|
| 1 | 20 | 5 | 5 |
| 2 | 20 | 2,5 | 5 |
| 3 | 20 | 3 | 15 |
| 4 | 20 | 3 | 60 |

Les échantillons 1 à 4 présentent un cuivrage uniforme. Les échantillons 1,2 et 3, après rinçage et séchage, sont passés dans un bain d'étain-plomb: ils se recouvrent d'une couche uniforme d'alliage brillant. L'échantillon 4 est découpé et une coupe est examinée au microscope après polissage: l'électrodépôt de cuivre obtenu est très homogène et il présente une épaisseur de 47 µm.

EXEMPLE 2:

A partir de l'oxyde cuivreux et du prépolymère polyimide décrit à l'exemple 1, on réalise un mélange à sec comprenant 50 parts en poids de chaque constituant. On incorpore ensuite dans ce mélange 0,5 parts en poids de peroxyde de dicumyle et 43 parts en poids de fibres de verre de 6 mm de longueur en moyenne. L'ensemble des matières est ensuite homogénéisé sur TURBULA®.

On prélève 60 g du compound ainsi obtenu. Cette fraction de compound est ensuite pastillée puis pressée à chaud de la manière indiquée ci-avant dans l'exemple 1. La plaquette de dimensions 100 × 100 × 2 mm obtenue est alors décapée en surface par sablage avec un sable siliceux de 80 mesh environ, puis elle est découpée en quatre échantillons carrés de 45 mm de côté. Les échantillons sont soigneusement rincés à l'eau sous pression, puis traités à 20 °C par une solution aqueuse de borohydrure de potassium présentant une concentration de 5% en poids. La durée du traitement réducteur est de 1 minute. Les échantillons réduits présentent des résistivités superficielles de l'ordre de quelques centaines Ω/□. La réduction opérée concerne une épaisseur de substrat de l'ordre du µm.

Il est procédé enfin à un cuivrage électrolytique en utilisant le même électrolyte que celui décrit à l'exemple 1. Les conditions de l'électrolyse sont les suivantes:

| Echantillon | Température °C | Densité de courant A/$dm_2$ | Durée en minute |
|---|---|---|---|
| 1 | 20 | 2,5 | 1 |
| 2 | 20 | 2,5 | 2 |
| 3 | 20 | 5 | 1 |
| 4 | 20 | 5 | 30 |

Sous 2,5 A/$dm^2$, au bout de 1 minute, le dépôt n'est pas continu en surface, il exsite quelques points de manque dans l'épaisseur (échantillon 1); au bout de 2 minutes, le dépôt de surface devient continu et l'épaisseur est cuivrée uniformément (échantillon 2). Sous 5 A/$dm^2$, le dépôt est déjà continu sur la surface et l'épaisseur au bout de 1 minute (échantillon 3). L'échantillon 4 présente un cuivrage uniforme.

EXEMPLE 3:

Une autre fraction du compound (100 g) préparé dans l'exemple 2 est utilisée pour surmouler un insert d'acier légèrement conique (longueur: 50 mm; diamètre maximum: 9,5 mm; diamètre minimum: 9 mm). Pour cela, on dépose la moitié du compound mis en œuvre dans un moule froid de dimensions 50 × 35 × 35 mm, puis la pièce métallique est couchée sur le compound et recouverte par la seconde moitié du compound. Le moule porté à 200 °C est pressé sous 200.$10^5$ Pa pendant 30 minutes, puis recuit 24 heures à 200 °C. Après démoulage, l'insert est extrait avec un chasse-goupille et la pièce est repercée dans l'axe de l'évidement avec une mèche de 10 mm.

La pièce est ensuite plongée pendant 15 minutes à 20 °C dans une solution aqueuse de borohydrure de sodium présentant une concentration de 3% en poids et tamponnée à pH 12.

Une jonction électrique est installée sur le haut de l'évidement et la pièce est plongée dans le bain d'électrolyse conforme à l'exemple 1 de telle sorte que l'électrode ne touche pas l'électrolyte. Le dépôt de cuivre est effectué sous 1 A/$dm^2$ pendant 30 minutes. Après électrolyse, seul le canal central est cuivré, le reste de la pièce (qui n'a pas subi de décapage préalable) demeurant parfaitement isolant.

EXEMPLE 4:

A 100 parts en poids de résine époxy du type épichlorhydrine/bisphénol A, commercialisée par

la Société CIBA sous la dénomination ARALDITE D®, sont ajoutées 50 parts en poids d'oxyde cuivreux de granulométrie comprise entre 0,5 et 3 µm. Le mélange est homogénéisé par agitation mécanique. A la pâte visqueuse obtenue, on ajoute alors 20 parts en poids de durcisseur commercialisé par la Société CIBA sous la dénomination HY 951®. L'ensemble est à nouveau homogénéisé et coulé dans un moule de 50 × 50 × 50 mm.

Après 10 heures à température ambiante (20 °C), la masse est totalement gélifiée. La réticulation est ensuite poursuivie en étuve à 50 °C pendant 5 heures.

Après démoulage, la pièce obtenue est décapée en surface par sablage avec un sable siliceux passant à la maille de 0,1 mm, puis elle est rincée dans l'eau d'une cuve à ultrasons et finalement elle est plongée pendant 15 minutes dans la solution de borohydrure conforme à l'exemple 3. La résistivité superficielle obtenue est de l'ordre de quelques dizaines Ω/□.

Après le traitement réducteur, la pièce est immergée dans un bain de nickelage électrochimique standard réduit à l'hypophosphite: concentration en sulfate de nickel 30 g/l; concentration en hypophosphite: 10 g/l; pH de 4,5 environ; température: 60 °C. En 4 heures de métallisation, on dépose ainsi un revêtement uniforme de nickel d'environ 4 µm d'épaisseur et parfaitement adhérent.

EXEMPLE 5:

A partir d'un mélange uniforme renfermant 70% en poids de polyhexaméthylène-adipamide et 30% en poids d'oxyde cuivreux de granulométrie voisine de 0,2 µm, on réalise de manière connue en soi des filaments continus de 30 decitex.

Un câble formé à partir de ces filaments continus est placé dans une solution aqueuse à 5% en poids de borohydrure de sodium pendant 30 minutes. Après rinçage et séchage, un des filaments constitutifs du câble est prélevé et on trouve qu'il présente une résistance ohmique de $5{,}3.10^4$ Ω/cm.

**Revendications**

1. Procédé de métallisation de substrats en matière plastique selon lequel on réalise d'abord un substrat isolant électriquement de forme appropriée consistant dans l'association d'une résine polymérique et de particules d'oxyde cuivreux et le cas échéant une ou plusieurs autres charges non conductrices et inertes dans les conditions de la réduction, on réduit au moins une partie de l'oxyde cuivreux en cuivre métallique, puis on procède ensuite au dépôt de la couche métallique souhaitée, ledit procédé étant caractérisé en ce que:

(a) la ou les surface(s) du substrat destinée(s) à recevoir, en tout ou partie, la couche métallique est (sont) soumise(s), avant le dépôt de la couche en question, à l'action réductrice d'un borohydrure;

(b) on opère la réduction avec le borohydrure de façon que la résistivité superficielle soit comprise entre 0,01 et $10^3$ Ω/□, avant le dépôt de la couche métallique souhaitée et,

(c) le dépôt de la couche est fait par voie électrochimique sans courant et/ou par voie électrolytique.

2. Procédé selon la revendication 1, caractérisé en ce que les proportions des constituants du substrat à métalliser sont choisies entre les limites suivantes (exprimant le pourcentage pondéral de chacun des constituants dans le substrat):

- de 25 à 90% d'oxyde cuivreux,
- de 0 à 50% d'autre(s) charge(s) inertes dans les conditions de la réduction,
- de 10 à 75% de résine polymérique.

3. Procédé selon les revendications 1 et 2, caractérisé en ce que les résines utilisées pour la confection du substrat à métalliser sont des résines thermoplastiques, des résines thermodurcissables, des élastomères ou des mélanges de résines entre elles.

4. Procédé selon la revendication 3, caractérisé en ce que les résines thermoplastiques utilisées sont choisies parmi les résines: polyoléfiniques, vinyliques, polystyréniques, polyamidiques, acryliques, les polyuréthanes linéaires et les polyesters saturés.

5. Procédé selon la revendication 3, caractérisé en ce que les résines thermodurcissables utilisées sont choisies parmi les prépolymères phénoliques, polyesters insaturés, époxydiques et polyimidiques.

6. Procédé selon l'une quelconque des revendications précédentes, caractérisé en ce que les borohydrures utilisables sont choisis parmi les borohydrures alcalins non substitués et les borohydrures substitués dans lesquels au plus trois atomes d'hydrogène de l'ion borohydrure ont été remplacés par des substituants inertes dans les conditions de réduction.

7. Procédé selon l'une quelconque des revendications précédentes, caractérisé en ce que l'agent réducteur est mis en contact avec le substrat, après sa mise en forme, sous forme d'une solution dans l'eau ou dans un mélange d'eau et d'un solvant polaire inerte dont la concentration, exprimée en pourcentage en poids d'hydrogène actif du borohydrure dans la solution, est comprise entre 0,05 et 1%.

8. Procédé selon l'une quelconque des revendications 1 à 7, caractérisé en ce que le dépôt de la couche métallique est fait par voie électrolytique.

9. A titre de moyens pour la mise en œuvre du procédé selon l'une quelconque des revendications 1 à 8 précédentes, les substrats constitués par l'association d'une résine polymérique avec des particules d'oxyde cuivreux et le cas échéant une ou plusieurs charges non conductrices électriquement et inertes dans les conditions de la réduction, obtenus après traitement avec un borohydrure et dont la partie réduite présente avant dépôt de la couche métallique souhaitée une résistivité superficielle comprise entre environ 0,01 Ω/□ et environ $10^3$ Ω/□.

## Claims

1. Process for metallizing substrates made of plastic, according to which a suitably shaped, electrically insulating substrate is first produced, consisting of the combination of a polymeric resin and particles of cuprous oxide and, where applicable, one or more other fillers which are nonconductive and inert under the conditions of the reduction, at least a part of the cuprous oxide is reduced to metallic copper, and the deposition of the required metal layer is then carried out, the said process being characterized in that:

(a) the surface(s) of the substrate intended to receive, overall or partially, the metal layer is (are) subjected, before the deposition of the layer in question, to the reducing action of a borohydride;

(b) the reduction is performed with the borohydride so that the surface resistivity is between 0.01 and $10^3$ Ω/□, before the deposition of the required metal layer, and

(c) the deposition of the layer is done by an electrochemical route without current and/or by an electrolytic route.

2. Process according to Claim 1, characterized in that the proportions of the components of the substrate to be metallized are chosen within the following limits (expressing the percentage by weight of each of the components in the substrate):

from 25 to 90% of cuprous oxide,

from 0 to 50% of other filler(s) inert under the conditions of the reduction, and

from 10 to 75% of polymeric resin.

3. Process according to Claim 1 to 2, characterized in that the resins used for manufacturing the substrate to be metallized are thermoplastic resins, thermosetting resins, elastomers or mixtures of resins with each other.

4. Process according to Claim 3, characterized in that the thermoplastic resins used are chosen from polyolefin, vinyl, polystyrene, polyamide and acrylic resins, linear polyurethanes and saturated polyesters.

5. Process according to Claim 3, characterized in that the thermosetting resins used are chosen from phenolic prepolymers and unsaturated polyesters, epoxides and polyimides.

6. Process according to any one of the preceding claims, characterized in that the borohydrides which may be used are chosen from unsubstituted alkali metal borohydrides and substituted borohydrides in which not more than three hydrogen atoms in the borohydride ion have been replaced by substituants which are inert under the conditions of reduction.

7. Process according to any one of the preceding claims, characterized in that the reducing agent is brought into contact with the substrate, after it has been shaped, in the form of a solution in water or in a mixture of water and of an inert polar solvent whose concentration, expressed in percentage by weight of active hydrogen of the borohydride in the solution, is between 0.05 and 1%.

8. Process according to any one of Claims 1 to 7, characterized in that the deposition of the metal layer is done by an electrolytic route.

9. As means for making use of the process according to any one of the above Claims 1 to 8, the substrates consisting of the combination of a polymer resin with particles of cuprous oxide and, where applicable, one or more electrically nonconductive fillers inert under the conditions of the reduction, which are obtained after treatment with a borohydride and whose reduced portion has, before deposition of the required metal layer, a surface resistivity of between approximately 0.01 Ω/□ and approximately $10^3$ Ω/□.

## Patentansprüche

1. Verfahren zum Metallisieren von Substraten aus Kunststoff, bei dem zunächst ein elektrisch isolierendes Substrat geeigneter Form, bestehend aus der Kombination eines polymeren Harzes mit Kupfer(I)-oxid-Teilchen und gegebenenfalls einem oder mehreren weiteren nichtleitenden und unter den Reduktionsbedingungen inerten Füllstoffen hergestellt, zumindest ein Teil des Kupfer(I)-oxids zu metallischem Kupfer reduziert und dann die gewünschte Metallschicht aufgebracht wird, dadurch gekennzeichnet, dass man

a) die Oberfläche(n) des Substrats, die ganz oder teilweise die Metallschicht erhalten soll(en), vor dem Aufbringen dieser Schicht der Reduktionswirkung eines Borhydrids unterwirft,

b) die Reduktion mit dem Borhydrid so vornimmt, dass der spezifische Oberflächenwiderstand vor dem Aufbringen der gewünschten Metallschicht 0,01 bis $10^3$Ω/□ beträgt und

c) die Schicht auf elektrochemischem Wege stromlos und/oder auf elektrolytischem Wege aufbringt.

2. Verfahren nach Anspruch 1, dadurch gekennzeichnet, dass die Mengenanteile der Bestandteile des Substrats, des metallisiert werden soll, innerhalb folgender Grenzen gewählt werden (die den auf das Gewicht bezogenen prozentualen Anteil jeder der Komponenten in dem Substrat angeben):

- 25 bis 90% Kupfer(I)-oxid,
- 0 bis 50% andere(r), unter den Reduktionsbedingungen inerte(r) Füllstoff(e),
- 10 bis 75% polymeres Harz.

3. Verfahren nach Anspruch 1 oder 2, dadurch gekennzeichnet, dass die zur Herstellung des Substrates, das metallisiert werden soll, verwendeten Harze thermoplastische Harze, wärmehärtbare Harze, Elastomere oder Gemische von Harzen untereinander sind.

4. Verfahren nach Anspruch 3, dadurch gekennzeichnet, dass die verwendeten thermoplastischen Harze ausgewählt werden unter: Polyolefinharzen, Vinylharzen, Polystyrolharzen, Polyamidharzen, Acrylharzen, linearen Polyurethanen und gesättigten Polyestern.

5. Verfahren nach Anspruch 3, dadurch gekennzeichnet, dass die verwendeten wärmehärtbaren Harze ausgewählt sind aus den Phenolharzprepolymeren, ungesättigten Polyestern, Epoxidharzen und Polyimidharzen.

6. Verfahren nach einem der vorangehenden Ansprüche, dadurch gekennzeichnet, dass die verwendbaren Borhydride ausgewählt werden aus den nicht substituierten Alkaliborhydriden und den substituierten Borhydriden, bei denen höchstens drei Wasserstoffatome des Borhydridions ersetzt worden sind durch unter den Reduktionsbedingungen inerte Substituenten.

7. Verfahren nach einem der vorangehenden Ansprüche, dadurch gekennzeichnet, dass das Reduktionsmittel mit dem geformten Substrat in Form einer Lösung in Wasser oder in einem Gemisch aus Wasser und einem inerten polaren Lösungsmittel, dessen Konzentration, angegeben als Gew.-% aktiver Wasserstoff des Borhydrids in der Lösung, 0,05 bis 1% beträgt, zusammengebracht wird.

8. Verfahren nach einem der Ansprüche 1 bis 7, dadurch gekennzeichnet, dass die Metallschicht auf elektrolytischem Wege aufgebracht wird.

9. Als Mittel zur Durchführung des Verfahrens nach einem der vorangehenden Ansprüche 1 bis 8 die Substrate, bestehend aus der Kombination aus einem polymeren Harz mit Teilchen von Kupfer(I)-oxid und gegebenenfalls einem oder mehreren elektrisch nichtleitenden und unter den Reduktionsbedingungen inerten Füllstoffen, erhalten nach Behandlung mit einem Borhydrid, deren reduzierter Teil vor dem Aufbringen der gewünschten Metallschicht einen spezifischen Oberflächenwiderstand zwischen etwa 0,01 Ω/□ und etwa $10^3$ Ω/□ beträgt.